# EUROPEAN PATENT SPECIFICATION

(11) **EP 3 944 408 B1**
(45) Date of publication and mention of the grant of the patent: **28.12.2022**
(21) Application number: 20879946.0
(22) Date of filing: 17.10.2020
(51) Int. Cl.: H01M 50/507, H01M 50/519, H01M 50/572, H05K 1/02, H05K 1/18

(54) **CONNECTION ASSEMBLY, BATTERY MODULE, BATTERY PACK AND APPARATUS**
VERBINDUNGSANORDNUNG, BATTERIEMODUL, BATTERIEPACK UND VORRICHTUNG
ENSEMBLE DE LIAISON, MODULE DE PILES, BLOC-PILES ET APPAREIL

(30) Priority: 21.10.2019 CN 201911001727; 21.10.2019 CN 201911002508
(43) Date of publication of application: 26.01.2022
(73) Proprietor: Contemporary Amperex Technology Co., Limited, Fujian PRC 352100 (CN)
(72) Inventor: XU, Wencai, Ningde, Fujian 352100 (CN); QIAN, Mu, Ningde, Fujian 352100 (CN); YAO, Jihua, Ningde, Fujian 352100 (CN); HUANG, Yincheng, Ningde, Fujian 352100 (CN); WANG, Xuguang, Ningde, Fujian 352100 (CN)
(74) Representative: Pfenning, Meinig & Partner mbB
(86) International application number: PCT/CN2020/121720
(87) International publication number: WO 2021/078079

(56) References cited:
- CN-A- 104 955 263
- CN-A- 109 997 248
- CN-A- 111 132 452
- CN-U- 207 149 613
- CN-U- 210 403 889
- CN-U- 210 744 018
- CN-U- 210 744 068
- US-A1- 2019 181 418
- US-A1- 2019 181 508
- US-B2- 9 699 893

## Description

### TECHNICAL FIELD

The present application relates to the technical field of energy storage devices, and relates to a connection assembly, a battery module, a battery pack, and a device.

### BACKGROUND

A battery module includes a battery cell and a connection assembly. The connection assembly includes a circuit board and a connecting sheet. The connecting sheet is connected to electrode leads of the battery cell, and the circuit board is connected to the connecting sheet, so as to collect a temperature and a voltage signal of the battery cell. In addition, the connecting sheet is bonded through an insulating film, so that a plurality of the connecting sheets become an integral structure, which facilitates assembly.

However, during a working process of the battery module, expansive force exists in the battery cells. Under the action of the expansive force of the battery cells, there is a risk that the insulating film may be torn, resulting in exposure of the connecting sheets and a risk of short circuit.

CN207149613U provides an attachment structure of a battery guide piece, it is overlapped in the electrode tip of multiple batteries, and includes: multiple battery guide pieces, there is a joint face and an electric power output portion on each battery guide piece; at least one connection diaphragm, it has pliability, and its side is set in distance provided with the battery guide piece, and make on the connection diaphragm formed with multiple elastic deformation portions, the elastic deformation portion is provided with multiple dissected valleys, dissected valley neighbor sets the battery guide piece, and side edge shape extension of the dissected valley along the battery guide piece, the connection diaphragm correspond to the electrode tip and be equipped with multiple perforation.

US20190181418A1 provides a battery pack including battery cells arranged in a first direction, a wiring board collecting state information about the battery cells, and a sensing portion including an input port through which the state information about the battery cells is input, an output port coupled to the wiring board and through which the state information about the battery cells is output, and a connection portion between the input and output ports. The connection portion extends in a curved shape with portions spaced apart from each other in a second direction crossing the first direction. Damage or dielectric breakdown of a conductive line transmitting signals relating to the state information about the battery cells may be prevented, and accumulation of stress in the conductive line or an insulating film may be prevented, because the conductive line or the insulating film is flexibly deformed in response to swelling of the battery cells.

### SUMMARY

The invention is set out in the appended set of claims.

### BRIEF DESCRIPTION OF DRAWINGS

In order to illustrate the technical solutions of the embodiments of the present application more clearly, the following briefly describes the accompanying drawings required for describing the embodiments of the present application. Apparently, the accompanying drawings in the following description show merely some embodiments of the present application, and those of ordinary skill in the art can still derive other drawings from the accompanying drawings without any creative efforts.
FIG. 1 is an exploded view of a battery module in a specific embodiment according to the present application;
FIG. 2 is a schematic structural diagram of a connection assembly of FIG. 1 in a specific embodiment;
FIG. 3 is an exploded view of FIG. 2;
FIG. 4 is a schematic structural diagram of a first insulating film in FIG. 3;
FIG. 5 is a partial enlarged view of part I in FIG. 4, where a weakened portion is a first embodiment;
FIG. 6 is a partial enlarged view of part I in FIG. 4, where a weakened portion is a second embodiment;
FIG. 7 is a partial enlarged view of part II in FIG. 4, where a weakened portion is a third embodiment;
FIG. 8 is a schematic structural diagram of a second insulating film in FIG. 3;
FIG. 9 is a partial enlarged view of part III in FIG. 8, where a weakened portion is a fourth embodiment;
FIG. 10 is a partial enlarged view of part III in FIG. 8, where a weakened portion is a fifth embodiment;
FIG. 11 is a schematic structural diagram of a weakened portion in a sixth embodiment;
FIG. 12 is a schematic structural diagram of a weakened portion in a seventh embodiment;
FIG. 13 is a top view of FIG. 2;
FIG. 14 is a sectional view in A-A direction of FIG. 13;
FIG. 15 is a partial enlarged view of part IV in FIG. 13;
FIG. 16 is a sectional view in B-B direction of FIG. 15;

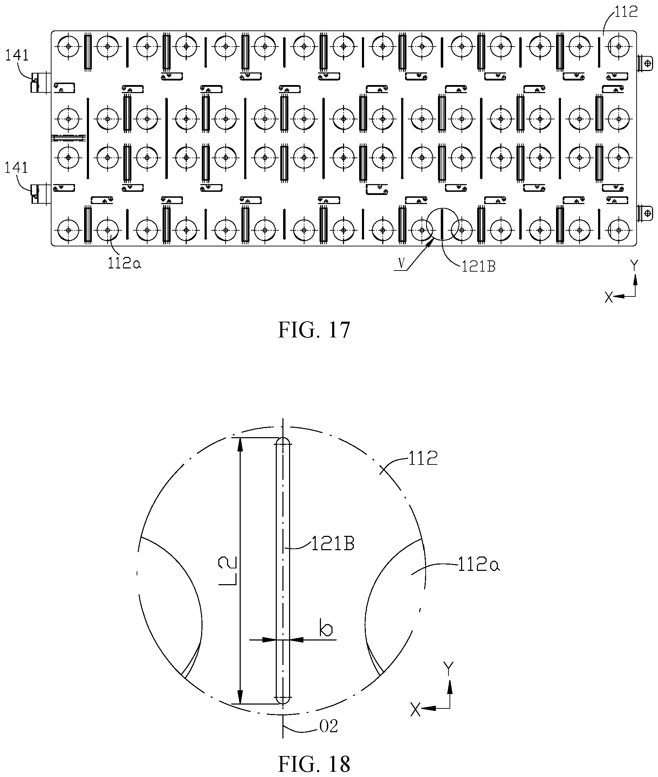

FIG. 17 is a bottom view of FIG. 2;
FIG. 18 is a partial enlarged view of part V in FIG. 17;
FIG. 19 is a top view of FIG. 2 in another embodiment;
FIG. 20 is a sectional view in C-C direction of FIG. 19;
FIG. 21 is a schematic structural diagram of a battery pack in a specific embodiment according to the present application.

Reference numerals:
P- battery pack;
A- battery module;
B- box body;
   B1- upper box body;
   B2- lower box body;
   B3- accommodating cavity;
1- connection assembly;
   11- insulating film;
      111- first insulating film;
         111a- first via hole;
      112- second insulating film;
         112a- second via hole;
   12- weakened portion;
      121- through hole;
         121a- first body portion;
         121b- first arc portion;
         121c- first arc wall;
         121g- opening;
         121h- first section;
         121k- second section;
         121m- third section;
         121A- first through hole;
         121B- second through hole;
      122- recess;
         122a- second body portion;
         122b- second arc portion;
         122c- second arc wall;
         122d- bottom wall;
         122A- first recess;
         122B- second recess;
   13- connecting sheet;
      131- connecting portion;
   14- circuit board;
      141- connector;
2- battery cell;
   21- electrode lead;
3- end plate;
5- first cable tie; and
6- second cable tie.

The accompanying drawings, which are incorporated into and constitute a part of the description, illustrate the embodiments of the present application and together with the description, serve to explain the principles of the present application.

### DESCRIPTION OF EMBODIMENTS

To better understand the technical solution of the present application, the embodiments of the present application are described below with reference to the accompanying drawings.

It should be clear that the described embodiments are merely some rather than all of the embodiments of the present application. All other embodiments derived by those of ordinary skill in the art based on the embodiments of the present application without creative efforts fall within the protection scope of the present application.

Terms used in the embodiments of the present application are merely for the purpose of describing specific embodiments, and are not intended to limit the present application. The singular forms of "a/an", "said" and "the" used in the embodiments of the present application and the appended claims are also intended to include plural forms, unless the context clearly implies otherwise.

It should be understood that the term "and/or" used herein merely describes an association relationship between associated objects, and indicates that three types of relationships may exist. For example, A and/or B may indicate that A exists alone, both A and B exist, or B exists alone. In addition, the character "/" used herein generally indicates that the associated objects are in an "or" relationship.

In the description of the present application, unless expressly specified and defined otherwise, the terms "first" and "second" are merely used for descriptive purposes, and cannot be understood as indicating or implying relative importance; unless otherwise specified or stated, the term "a plurality of" means two or more than two; and the terms "connect", "fasten", etc. should all be understood in a broad sense. For example, "connection" may be a fixed connection, a detachable connection, an integral connection, or an electrical connection; and may be a direct connection or an indirect connection by means of an intermediate medium. Those of ordinary skill in the art may appreciate the specific meanings of the foregoing terms in the present application according to specific conditions.

It should be noted that the orientation terms such as "up", "down", "left", and "right" described in the embodiments of the present application are described from the perspective shown in the accompanying drawings, and should not be understood as a limitation to the embodiments of the present application. In addition, in the context, it should further be understood that when it is mentioned that an element is connected "above" or "below" another element, the element may be directly connected "above" or "below" another element, or may be indirectly connected "above" or "below" another element by means of an intermediate element.

The embodiments of the present application provide a device using a battery cell 2 as a power supply, a battery pack, a battery module A, and a connection assembly 1. The device using the battery cell 2 as a power supply includes a mobile device such as a vehicle, a ship, or a light aircraft. The device includes a power source, where the power source is used to provide driving force for the device, and the power source may be configured as the battery module A that provides electrical energy for the power source. The driving force for the device may be simply electrical energy, or may include electrical energy and other energy (such as mechanical energy). The power source may be the battery module A (or the battery pack), or the power source may be the battery module A (or the battery pack) and an engine, etc. Therefore, any device that can use the battery cell 2 as a power supply falls within the protection scope of the present application.

A vehicle is taken as an example. A vehicle in the embodiments of the present application may be a new-energy vehicle, and the new-energy vehicle may be a battery electric vehicle, a hybrid electric vehicle, an extended-range vehicle, or the like. The vehicle may include a battery pack and a vehicle body. The battery pack is provided in the vehicle body. The vehicle body is further provided with a driving motor, and the driving motor is electrically connected to the battery pack. The battery pack provides electrical energy, and the driving motor is connected to wheels on the vehicle body by means of a transmission mechanism, so as to drive the vehicle to move forward. Specifically, the battery pack may be horizontally arranged at the bottom of the vehicle body.

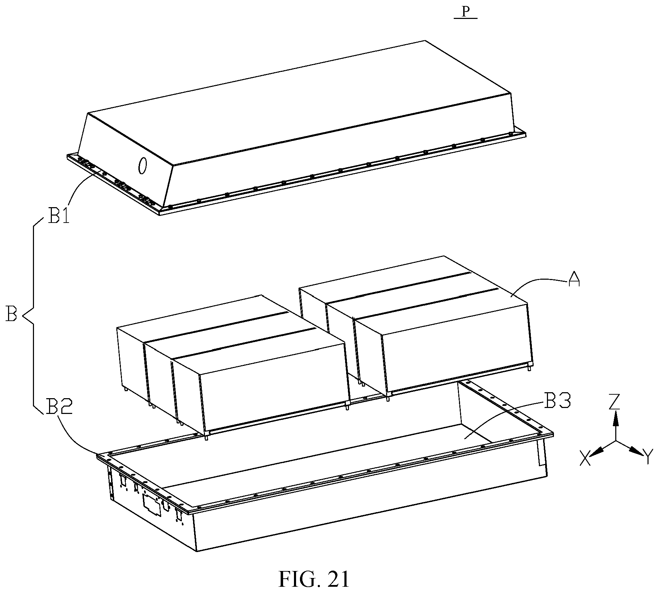

As shown in FIG. 21, a battery pack P includes a box body B and a battery module A of the present application. The box body B includes an accommodating cavity B3, and the battery module A is accommodated in the accommodating cavity B3. There may be one or more battery modules A, and the plurality of battery modules A are arranged in the accommodating cavity B3. A type of the box body B is not limited, and may be a frameshaped box body, a disk-like box body, a box-like box body, or the like. Specifically, as shown in FIG. 21, the box body B may include a lower box body B2 that accommodates the battery module A, and an upper box body B1 that cooperates with the lower box body B2 for closing.

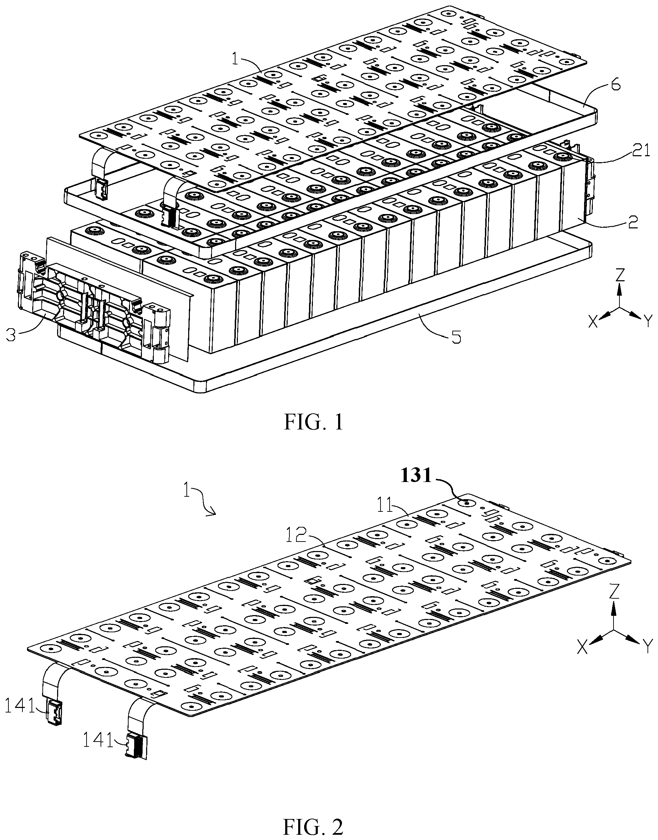

More specifically, as shown in FIG. 1, the battery module A includes a plurality of battery cells 2 and a frame structure for fastening the battery cells 2, where the plurality of battery cells 2 are stacked with each other along a length direction X. The frame structure includes a end plate 3, and the end plate 3 is located at both ends of the battery cells 2 along the length direction X, so as to restrict the movement of the battery cells 2 along the length direction X. In addition, in a specific embodiment, the frame structure may further include side plates (not shown in the figure). Two side plates are located on both sides of the battery cells 2 along a width direction Y, and the side plates are connected to the end plates 3 to form the frame structure. In another preferred embodiment, the frame structure may not be provided with the side plates. After being stacked, the battery cells 2 are connected through a first cable tie 5 or connected through the first cable tie 5 and second cable tie 6, and the end plates 3 and the cable ties form the foregoing frame structure.

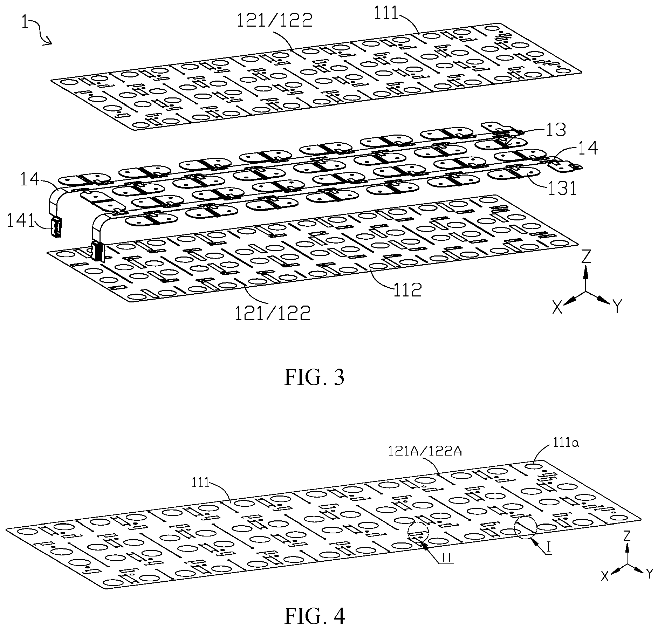

Specifically, the battery cell 2 includes electrode leads 21, and each battery cell 2 includes a positive electrode lead and a negative electrode lead. In the battery module A, the plurality of battery cells 2 are electrically connected and specifically may be connected in series and/or in parallel, and the battery cells 2 are connected through connecting sheets 13 (refer to FIG. 3). For example, when the battery cells 2 are connected in series, a positive electrode lead of one battery cell 2 is connected to a negative electrode lead of another battery cell 2 through a connecting sheet 13.

As shown in FIG. 1, the battery module A further includes a connection assembly 1, and the connection assembly 1 is placed at an end close to the electrode leads 21 of the battery cells 2. In the embodiment shown in FIG. 1, the connection assembly 1 is above the battery cells 2.

In a specific embodiment, as shown in FIG. 2 and FIG. 3, the connection assembly 1 includes: a circuit board 14 and a connecting sheet 13, and the connecting sheet 13 is configured to connect the electrode leads 21 of the battery cell 2. As shown in FIG. 3, the connection assembly 1 includes a plurality of the connecting sheets 13, and setting positions of the connecting sheets 13 change with positions and connection manners of the battery cells 2. The circuit board 14 is electrically connected to the connecting sheets 13, so that information about the battery cells 2 can be collected by means of the connecting sheets 13, and a collected signal is output by a connector 141. A specific circuit board 14 may be a FPC, a PCB, or the like, which is not specifically limited herein, as long as the information about the battery cells 2 can be collected.

In addition, in this embodiment, as shown in FIG. 3, the connection assembly 1 further includes an insulating film 11, and the insulating film 11 is connected to both the circuit board 14 and the connecting sheets 13, so that the circuit board 14 and the connecting sheets 13 are connected together by means of the insulating film 11. In addition, the insulating film 11 further provides a function of insulation, thereby preventing short circuit between electrical elements.

In another specific embodiment, the connection assembly 1 includes a plurality of connecting sheets 13, and the connecting sheets 13 are used to connect the electrode leads 21 of the battery cells 2 so as to implement electrical connection between the battery cells 2. In addition, the connection assembly 1 further includes an insulating film 11, the insulating film 11 is connected to the connecting sheets 13, and the insulating film 11 further provides a function of insulation, thereby preventing short circuit between the connecting sheets 13. Specifically, as described above, in the connection assembly 1, the connecting sheets 13 are connected to the respective battery cells 2. As the battery cell 2 expands during a working process, the battery cell 2 shifts under the action of expansive force, and drives a connected connecting sheet 13 to shift. When the expansive force is greater than a specific value, the insulating film 11 of the connection assembly 1 is pulled, resulting in a risk that the insulating film 11 may be torn.

To solve the technical problem, in the present application, the insulating film 11 is provided with a weakened portion 12. Compared with positions where the weakened portion 12 is not provided, the weakened portion 12 has weaker strength. When force is applied, deformation and/or breakage occur/occurs at the position of the weakened portion 12, thereby reducing the risk of tearing at other positions of the insulating film 11, improving the flexibility of the connection assembly 1, and reducing the risk of exposure of the connecting sheets 13 due to the tearing of the insulating film 11, such that the risk of short circuit between the connecting sheets 13 and other conductive components is reduced, and the safety performance of the connection assembly 1 and the battery module A is improved.

In addition, when the connection assembly 1 includes the circuit board 14 and the plurality of the connecting sheets 13, the weakened portion 12 is located between the adjacent connecting sheets 13, and/or the weakened portion 12 is located between the connecting sheet 13 and the circuit board 14, so that when the weakened portion 12 fractures under the action of the expansive force, a fractured part is between the adjacent connecting sheets 13, and/or the fractured part is between the connecting sheet 13 and the circuit board 14. Therefore, the risk of exposure of the connecting sheets 13 and/or the circuit board 14 is relatively low, and the insulation performance of the connection assembly 1 and the battery module A is further improved.

When the connection assembly 1 includes the plurality of the connecting sheets 13, the weakened portion 12 is located between the adjacent connecting sheets 13, so that when the weakened portion 12 fractures under the action of expansive force, the fractured part is between the adjacent connecting sheets 13. Therefore, the risk of exposure the connecting sheets 13 is relatively low, and the insulation performance of the connection assembly 1 and the battery module A is further improved.

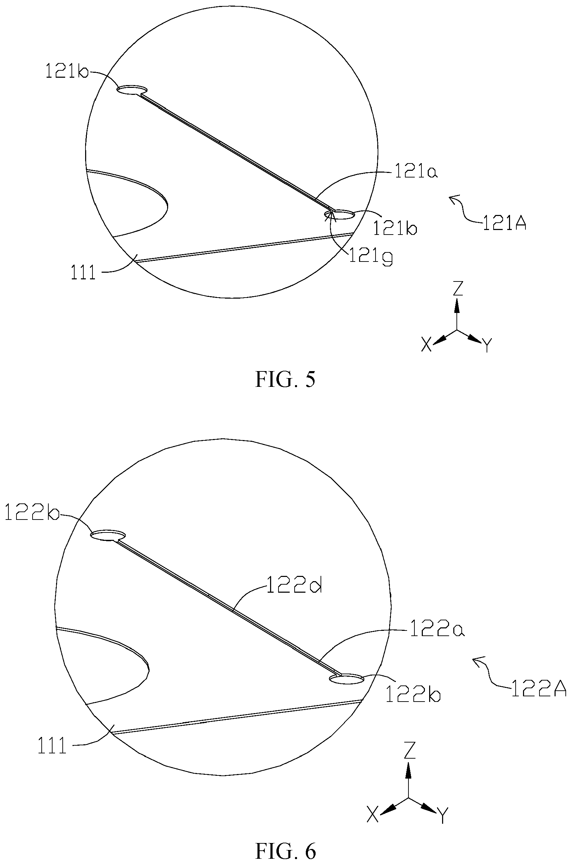

Specifically, as shown in FIG. 4 and FIG. 5, a dimension of the weakened portion 12 along the length direction X of the connection assembly 1 is smaller than a dimension of the weakened portion 12 along the width direction Y. Because the expansive force from the battery cell 2 is along the length direction X (a direction in which the battery cells 2 are stacked), the weakened portion 12 easily deforms along the length direction X when subjected to the expansive force, and the strength of the insulating film 11 without the weakened portion 12 is further improved.

In a possible design, as shown in FIG. 3, the insulating film 11 is provided with a through hole 121 and/or a recess 122, and the through hole 121 and/or the recess 122 are/is the foregoing weakened portion 12.

In this embodiment, the through hole 121 has the advantage of a simple structure, and there is relatively little processing difficulty to provide the through hole 121 in the insulating film 11 with a small thickness. The recess 122 includes a bottom wall, the bottom wall of the recess 122 has a relatively small thickness, and deformation and/or breakage easily occur/occurs at the position with a relatively small thickness, that is, the insulating film 11 is still integral after the recess 122 is provided, which can further improve the insulation performance of the connection assembly 1.

In the embodiment shown in FIG. 3, the insulating film 11 includes a first insulating film 111 and a second insulating film 112. The first insulating film 111 and the second insulating film 112 are arranged along the height direction Z of the battery module A, and they are connected together. Specifically, the two insulating films are connected by means of hot pressing. In addition, at least part of the circuit board 14 and the plurality of the connecting sheets 13 are located between the first insulating film 111 and the second insulating film 112. After the two insulating films are connected, the connecting sheets 13 and the circuit board 14 are connected to form a module, and the two insulating films can further implement insulation between the circuit board 14 and the battery cells 2. Therefore, the connection assembly 1 can provide the function of insulation, and can further provide the functions of connecting the battery cells 2 and collecting information during a working process of the battery cells 2.

In another embodiment, in the connection assembly 1, at least part of the plurality of the connecting sheets 13 are located between the first insulating film 111 and the second insulating film 112, and after the two insulating films are connected to the connecting sheets 13, the plurality of the connecting sheets 13 are connected to form a module, and the two insulating films can further implement insulation between the connecting sheets 13. Specifically, at least one of the first insulating film 111 and the second insulating film 112 is provided with the foregoing weakened portion 12. Therefore, the first insulating film 111 can deform and/or fracture at the weakened portion 12 under the action of expansive force, thereby improving the flexibility of the first insulating film 111; and the second insulating film 112 can deform and/or fracture at the weakened portion 12 under the action of the expansive force, thereby improving the flexibility of the second insulating film 112.

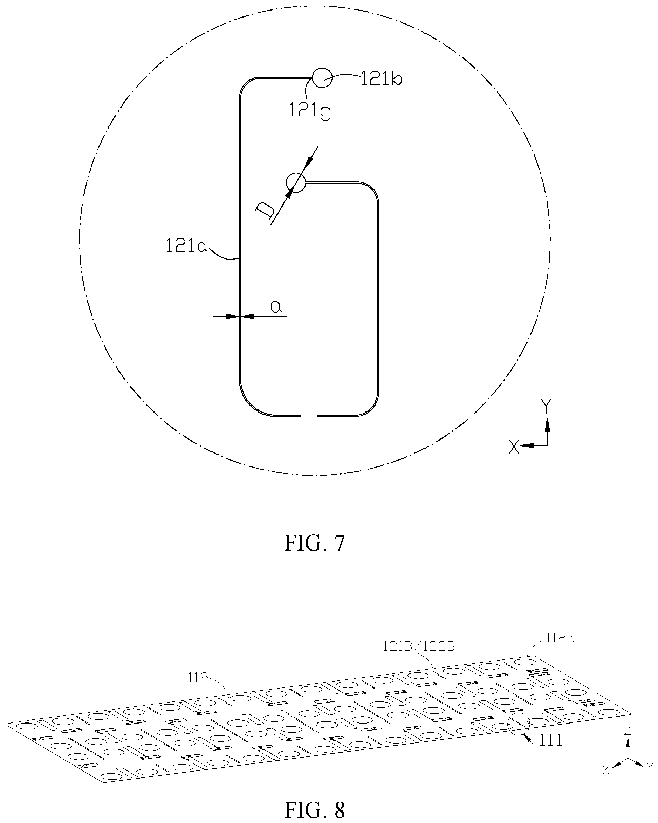

In a possible design, as shown in FIG. 4, the weakened portion 12 of the first insulating film 111 is provided as a first through hole 121A or a first recess 122A; or as shown in FIG. 8, the weakened portion 12 of the second insulating film 112 is provided as a second through hole 121B or a second recess 122B. As shown in FIG. 5, the first through hole 121A (or the second through hole 121B) includes a first body portion 121a and a first arc portion 121b, and along the extension direction of the first body portion 121a, both ends of the first body portion 121a are connected to first arc portions 121b. As shown in FIG. 6, the first recess 122A (or the second recess 122B) includes a second body portion 122a and a second arc portion 122b, and along the extension direction of the second body portion 122b, both ends of the second body portion 122a are connected to second arc portion 122b.

It should be noted that taking the first through hole 121A (or the second through hole 121B) as an example, the extension direction of the first body portion 121a refers to a direction in which one end with the largest dimension is located in the first body portion 121a, and the first body portion 121a does not necessarily extend in one direction. To be specific, the first body portion 121a may be a structure extending in one direction as shown in FIGS. 5, 6, 9, and 10 (for example, the first body portion 121a extends along the width direction Y of the connection assembly 1), or may be a structure that extends in a plurality of directions as shown in FIGS. 7, 11, and 12, that is, the first body portion 121a is a bent structure (for example, one part of the first body portion 121a extends along the length direction X of the connection assembly 1, and the other part extends along the width direction Y of the connection assembly 1). Therefore, regardless of the structure of the first body portion 121a, both ends of the first body portion 121a are provided with the first arc portion 121b.

In this embodiment, when the connection assembly 1 is subjected to expansive force, the insulating film deforms and/or fractures at the position of the weakened portion 12, and an arc side wall of the first arc portion 121b can reduce stress concentration of the weakened portion 12, to reduce a risk of the two insulating films continuing to be torn under the action of the expansive force, thereby improving the strength of the insulating film.

In a possible design, an arc length of the first arc portion 121b is greater than a width dimension of an end of the first body portion 121a, where the end of the first body portion 121a is a part of the first body portion 121a that is connected to the first arc portion 121b, that is, the arc length of the first arc portion 121b is greater than the width dimension of the end of the first body portion 121a that is connected to the first arc portion.

For example, a width dimension a of the end of the first body portion 121a is less than 0.3 mm, and the first body portion 121a with the width can further reduce a risk that welding slag falls into the battery module A from the weakened portion 12. Preferably, the width dimension a of the end of the first body portion 121a is less than or equal to 0.2 mm; more preferably, the width dimension a of the end of the first body portion 121a is less than or equal to 0.1 mm. Both ends of the first body portion 121a along its extension direction have first arc walls 121c, and the first arc walls 121c are the foregoing first arc portions 121b.

When the width of the first body portion 121a is the same at various positions (for example, a section of the first body portion 121a is rectangular), the arc length of the first arc portion 121b is greater than the width dimension a of the first body portion 121a.

Specifically, in the embodiments shown in FIGS. 5 and 7, the weakened portion 12 of the first insulating film 111 is provided as the first through hole 121A, the first through hole 121A includes a first body portion 121a and a first arc portion 121b. The first arc portion 121b is a circular structure having an opening 121g, and the first arc portion 121b communicates with the first body portion 121a through the opening 121g, and they form the foregoing first through hole 121A. The first body portion 121a may be a structure extending in one direction, or may be a structure (bent structure) extending in a plurality of directions. A diameter D of the first arc portion 121b is greater than a width dimension a of the first body portion 121a. When the diameter D of the first arc portion 121b with a circular arc shape is greater than the width of the first body portion 121a, stress concentration of the weakened portion 12 at the first arc portion 121b can be further reduced.

More specifically, the section of the first body portion 121a is rectangular, and the width dimension a of the first body portion 121a is less than 0.3 mm, and the diameter D of the first arc portion 121b is less than 0.5 mm. In this embodiment, the width of the first body portion 121a is relatively small, and the diameter of the first arc portion 121b is slightly greater than the width of the first body portion 121a. When the weakened portion 12 is a through hole or a recess, a risk that welding slag falls into the battery module A from the first body part 121a can be reduced. In this embodiment, the first arc portion 121b with a circular arc structure has the advantages of easy molding, and each position thereof receives uniform force, which can further reduce a risk of stress concentration. In addition, the first arc portion 121b with a larger diameter can further reduce a risk that the first arc portion 121b is torn after the force is applied. Certainly, the first arc portion 121b may be a circular structure as shown in FIGS. 5 to 7, but does not necessarily be a circular structure, as long as it is an arc structure.

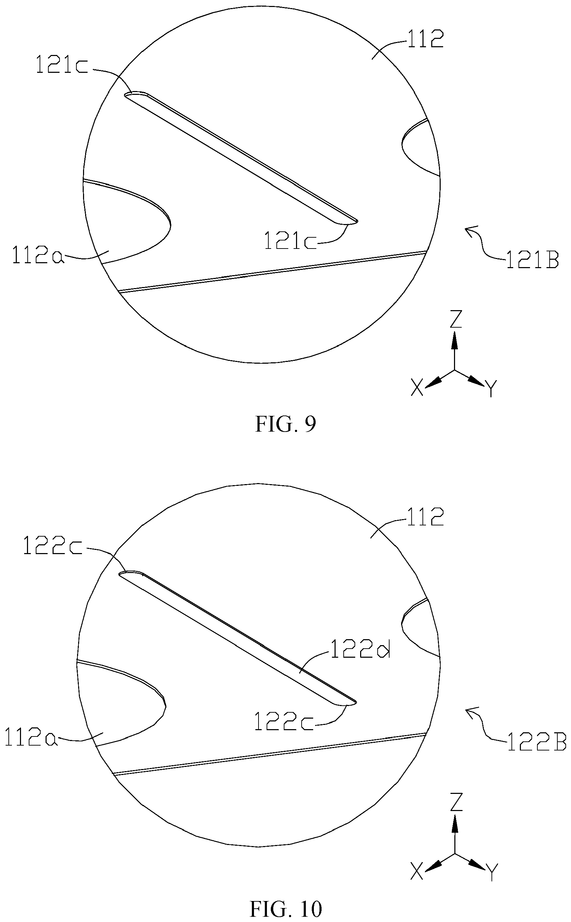

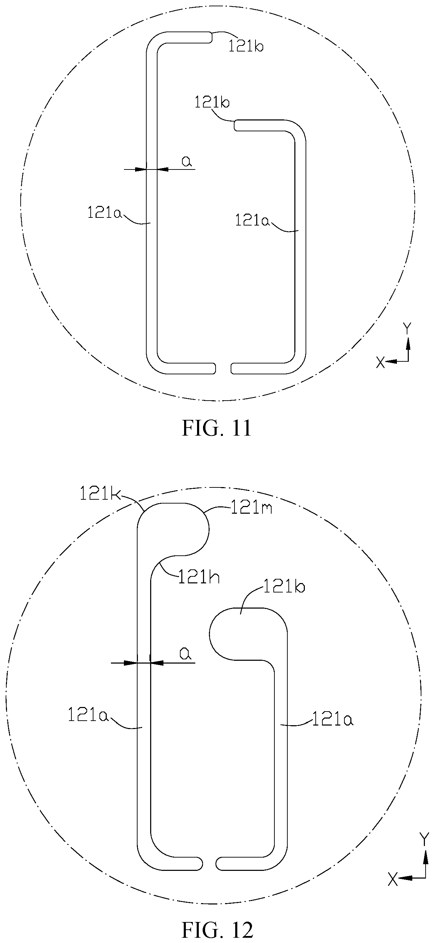

In another possible design, as shown in FIGS. 9 and 11, the weakened portion 12 of the second insulating film 112 is provided as the second through hole 121B, and the second through hole 121B includes a first body portion 121a and a first arc portion 121b, and the weakened portion 12 may be an elongated hole. Specifically, a section of the first body portion 121a is rectangular, the first arc portion 121b is a circular arc structure, and the first arc portion 121b is tangent to two side walls of the first body portion 121a. In this case, a diameter D of the first arc portion 121b is equal to a width dimension a of the first body portion 121a. In this embodiment, when the weakened portion 12 is the elongated hole, it has the advantages of a simple structure and convenient molding, and the diameter D of the first arc portion 121b is small, which can reduce a risk that welding slag passes through the first arc portion 121b and falls into the connection assembly 1.

The first body portion 121a may be a structure extending in one direction, as shown in FIG. 9, or may be a structure (bent structure) extending in a plurality of directions, as shown in FIG. 11. In addition, regardless of how the first body portion 121a extends, both ends thereof are provided with the foregoing first arc portions 121b.

In still another possible design, as shown in FIG. 12, a section of the first body portion 121a is rectangular, and the first body portion 121a may be a structure extending in one direction, or may be a structure (bent structure) extending in a plurality of directions. The first arc portion 121b includes a first section 121h, a second section 121k, and a third section 121m. The third section 121m is between the first section 121h and the second section 121k, and the first section 121h, the third section 121m, and the second section 121k smoothly transition with each other. The first section 121h and the second section 121k each are a circular arc structure, and the first section 121h and the second section 121k are tangent to the two side walls of the first body part 121a, respectively. The third section 121m is a curved structure, or the third section 121m is a combination of an arc structure and a linear structure.

In this embodiment, the first arc portion 121b may include one or more third sections 121m, and the third sections 121m are between the first section 121k and the second section 121h and smoothly transition with each other. Therefore, the first arc portion 121b may be an irregular arc structure or a regular arc structure. For example, the first arc portion 121b may be a partial elliptical structure.

Specifically, as shown in FIG. 12, a section dimension of the first arc portion 121b is greater than a width dimension a of the first body portion 121a. In this case, the first arc portion 121b can reduce stress concentration of the weakened portion 12 at this position. The width dimension a of the first body portion 121a is less than 0.3 mm, and the first body portion 121a with a relatively small dimension can reduce a risk that welding slag falls into the battery module A from the weakened portion 12.

In order to further improve the reliability of the connection assembly 1, when the first insulating film 111 and the second insulating film 112 each are provided with the weakened portion 12, along the height direction Z of the connection assembly 1, the weakened portion 12 of the first insulating film 111 is arranged corresponding to the weakened portion 12 of the second insulating film 112." Arranged corresponding " herein means that the weakened portion 12 located on the second insulating film 112 is disposed close to the weakened portion 12 located on the first insulating film 111. In this embodiment, when the weakened portions 12 of the two insulating films are close to each other, under the action of the expansive force, positions of the deformation and/or fracture of the two insulating films are the same or close, so that the two insulating films can deform and/or fracture synchronously, which can improve the deformation consistency of the connection assembly 1 under the action of the expansive force.

In a possible design, a projection of the weakened portion 12 of the first insulating film 111 along the height direction Z at least partially coincides with a projection of the weakened portion 12 of the second insulating film 112 along the height direction Z, and under the action of the expansive force, the extent of deformation and/or fracture of the two insulating films is closer, thereby further improving the deformation consistency of the connection assembly 1.

The projections of the two weakened portions 12 respectively located on the first insulating film 111 and the second insulating film 112 along the height direction Z at least partially coinciding with each other means as follows: Along the height direction Z, the projection of one weakened portion 12 falls within the projection range of the other weakened portion 12, and in this case, a coinciding area of the projections of the two weakened portions 12 are relatively large, which can further improve the deformation consistency of the two insulating films. Alternatively, the projections of the two weakened portions 12 have one coinciding part and one non-coinciding part, and because a coinciding projection area of the two weakened portions 12 is reduced, when the two weakened portions 12 are both through holes, a risk that welding slag passes through the coinciding projection area of the two weakened portions 12 and falls into the battery module A can be reduced.

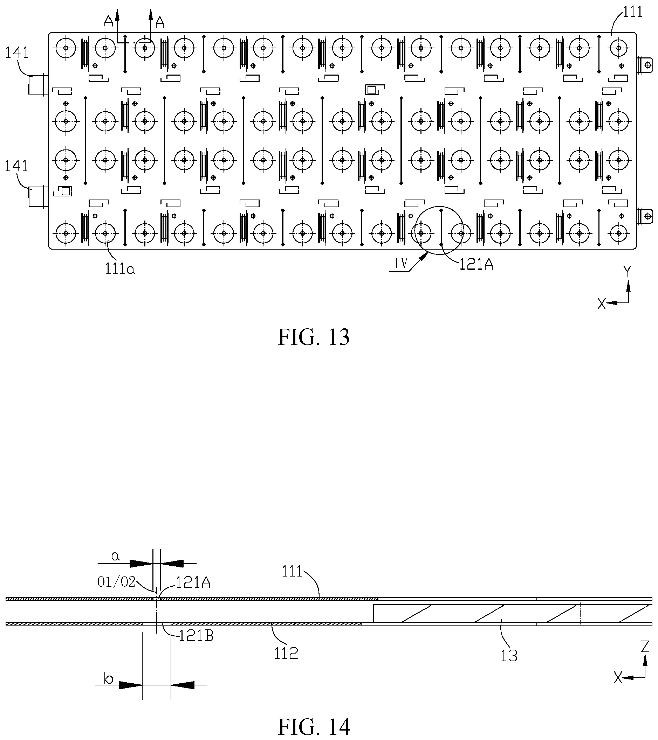

As shown in FIG. 14, in an embodiment not according to the present application, a center line O1 of the weakened portion 12 of the first insulating film 111 coincides with a center line 02 of the weakened portion 12 of the second insulating film 112. When the center lines of the two weakened portions 12 coincide with each other, it can be ensured that the projections of the two weakened portions 12 overlap, and the coinciding area of the two projections is relatively large, that is, the projection of the weakened portion 12 with a smaller area completely falls within the projection range of the weakened portion 12 with a larger area, such that the flexibility of the connection assembly 1 is relatively high.

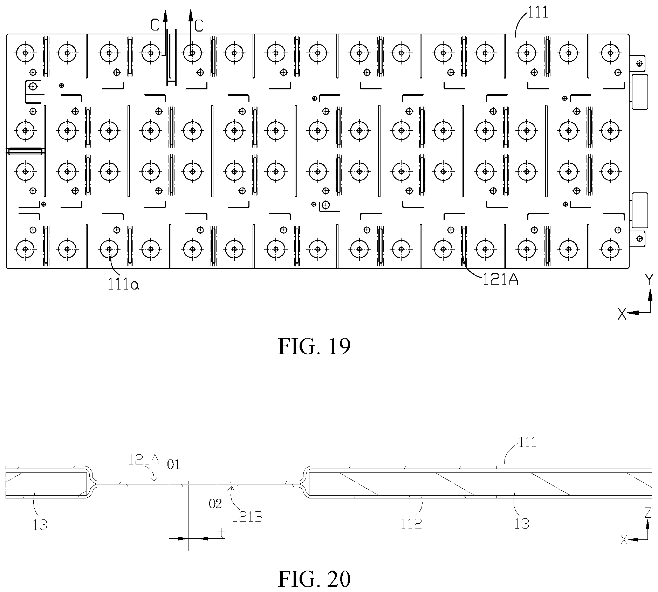

The weakened portion 12 of the first insulating film 111 and the weakened portion 12 of the second insulating film 112 are arranged in a staggered manner, there is a preset distance between the weakened portion 12 of the first insulating film 111 and the weakened portion 12 of the second insulating film 112, and a minimum distance between them is t, and 0 < t ≤0.5 mm. In the embodiment shown in FIG. 20, there is a preset distance between the weakened portion 12 of the first insulating film 111 and the weakened portion 12 of the second insulating film 112 along the length direction X of the connection assembly 1, and the minimum distance between an edge of the weakened portion 12 of the first insulating film 111 and an edge of the weakened portion 12 of the second insulating film 112 close to the edge of the weakened portion 12 of the first insulating film 111 is t, and 0 < t ≤ 0.5 mm.

In this embodiment, the distance between the weakened portion 12 of the first insulating film 111 and the weakened portion 12 of the second insulating film 112 is relatively small, that is, they are close to each other. Therefore, under the action of the expansive force, the deformation consistency between the weakened portion 12 of the first insulating film 111 and the weakened portion 12 of the second insulating film 112 is still relatively high, so that the flexibility of the connection assembly 1 is relatively high. In addition, when the weakened portion 12 of the first insulating film 111 and the weakened portion 12 of the second insulating film 112 do not communicate in the height direction Z, even if welding slag can enter the connection assembly 1 through the weakened portion 12 of the first insulating film 111, it cannot enter the battery module A through the weakened portion 12 of the second insulating film 112, that is, the welding slag can be effectively prevented from entering the battery module A.

Specifically, as shown in FIG. 20, along the height direction Z, the first insulating film 111 and the second insulating film 112 overlap together, and an overlapping part of the two is between the weakened portion 12 of the first insulating film 111 and the weakened portion 12 of the second insulating film 112.

In this embodiment, the overlapping part of the first insulating film 111 and the second insulating film 112 is between the adjacent connecting sheets 13 and between the weakened portions 12 of the two insulating films 11, and along the length direction X, an overlapping dimension of the two insulating films 11 is equal to the minimum distance t between the weakened portion 12 of the first insulating film 111 and the weakened portion 12 of the second insulating film 112, that is, the overlapping dimension of the two is 0 < t ≤ 0.5 mm, for example, the overlapping dimension t may be specifically 0.4 mm, etc.

In this embodiment, the first insulating film 111 and the second insulating film 112 overlap together to increase a connection area between the two, thereby improving the reliability of the connection between the two. In addition, the overlapping dimension t may be controlled to make the two weakened portions 12 close to each other, thereby reducing the processing difficulty of the insulating film 11 and improving the flexibility of the connection assembly 1.

It should be noted that when the overlapping dimension t of the two insulating films 11 is reduced, the first insulating film 111 and the second insulating film 112 deform more easily under the action of the expansive force, thereby further improving the flexibility of the connection assembly 1; and when the overlapping dimension t increases, the processing difficulty of the first through hole 121A and the second through hole 121B during the molding of the connection assembly 1 can be reduced, and the reliability of the connection between the first insulating film 111 and the second insulating film 112 can be improved. Therefore, in actual working conditions, the overlapping dimension t of the first insulating film 111 and the second insulating film 112 may be set in comprehensive consideration of the above two factors, and not limited to t ≤ 0.5 mm.

In the above embodiments, the weakened portion 12 of the first insulating film 111 may be provided as the first through hole 121A, and the weakened portion 12 of the second insulating film 112 may be provided as the second through hole 121B. When both the weakened portions are through holes, the two insulating films 11 deform more easily under the action of the expansive force, thereby improving the flexibility of the connection assembly 1.

Specifically, when a width dimension a of the first through hole 121A is smaller than a width dimension b of the second through hole 121B, and the width dimension a of the first through hole 121A is smaller, a risk that welding slag enters the connection assembly 1 through the first through hole 121A can be reduced.

When the first through hole 121A and the second through hole 121B are two through holes, a dimension in a direction with a larger dimension is defined as the length of the through hole, and a dimension in a direction with a smaller dimension is defined as the width of the through hole. In other words, regardless of shapes of the first through hole 121A and the second through hole 121B, the length thereof is greater than the width.

In this embodiment, because dimensions of the two through holes along the width direction Y are the largest, a dimension a of the first through hole 121A along the length direction X is the width dimension of the first through hole 121A, and a dimension b of the second through hole 121B along the length direction X is the width dimension of the second through hole 121B, and the widths of the two through holes satisfy the following: the width of the first through hole 121A located on the first insulating film 111 is smaller than the width of the second through hole 121B located on the second insulating film 112.

In addition, along the extension direction of the first body portion 121a (for example, the width direction Y of the connection assembly), a dimension of the second through hole 121B is L2, a dimension of the first through hole 121A is L1, and as described above, along the extension direction of the first body portion 121a, the dimension L1 of the first through hole 121A is the length of the first through hole 121A, and the dimension L2 of the second through hole 121B is the length of the second through hole 121B. Therefore, a relationship between the length L1 of the first through hole 121A and the length L2 of the second through hole 121B is: L1 > L2. In this embodiment, the second through hole 121B with a smaller length can reduce a risk that impurities such as welding slag entering the connection assembly 1 through the first through hole 121A enter the battery module A through the second through hole 121B.

In a specific embodiment, the first through hole 121A of the first insulating film 111 may be the structure shown in FIG. 5, and the second through hole 121B of the second insulating film 112 may be the structure shown in FIG. 9. Specifically, as shown in FIG. 5, the first through hole 121A includes a first body portion 121a; along an extension direction of the first body portion 121a, ends of the first body portion 121a are provided with first arc portions 121b, and the first arc portions 121b is a circular structure having an opening 121g; and the first arc portion 121b communicates with the first body portion 121a through the opening 121g. As shown in FIG. 9, the second through hole 121B is an elongated hole.

In addition, as shown in FIG. 14, a center line O1 of the first through hole 121A coincides with a center line 02 of the second through hole 121B, that is, the first through hole 121A communicates with the second through hole 121B along the height direction Z. Under the action of the expansive force, both the first insulating film 111 and the second insulating film 112 can deform, so that the flexibility of the connection assembly 1 is relatively high.

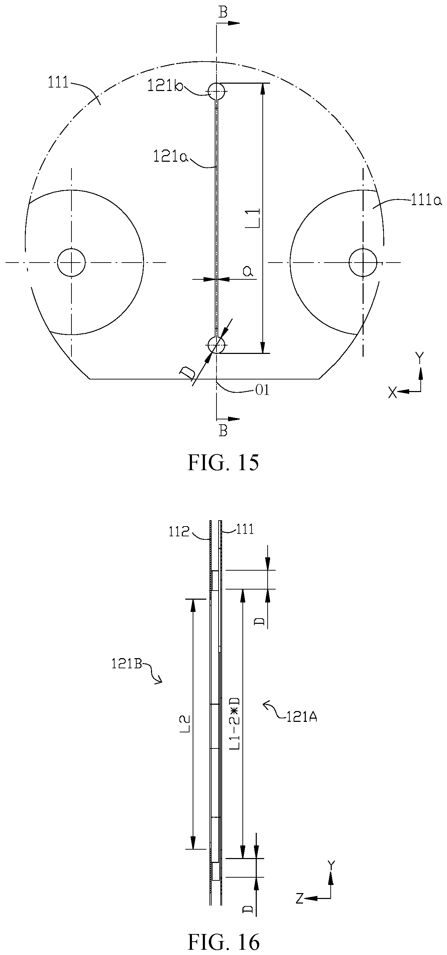

Specifically, L2 ≤ L1-2^{∗}D, where as shown in FIGS. 15 and 16, the dimension D is the diameter of the first arc portion 121b of the first through hole 121A, L1 is the length dimension of the first through hole 121A, and L2 is the length dimension of the second through hole 121B. In addition, the center line O1 of the first through hole 121A coincides with the center line O1 of the second through hole 121B.

In this embodiment, as shown in FIG. 5, when the first through hole 121A includes the first arc portion 121b with a relatively large diameter D, there is a relatively high risk that welding slag enters the connection assembly 1 from the first arc portion 121b. In order to reduce the risk that welding slag enters the battery module A through the first arc portion 121b, the second insulating film 112 is not provided with a through hole structure at a position corresponding to the first arc portion 121b. That is, the length L2 of the second through hole 121B and the length L1 of the first through hole 121A satisfy L2 ≤ L1-2^{∗}D, thereby reducing a risk that the welding slag enters the inner cavity of the battery module A after entering the connection assembly 1 through the first arc portion 121b.

In the above embodiments, in order to effectively prevent metal particles from entering the inner cavity of the battery module A from the weakened portion 12 while ensuring the release of the expansive force, the width dimension a of the first body portion 121a is less than 0.3 mm, preferably, a ≤ 0.2 mm, and more preferably, a ≤ 0.1 mm.

Certainly, the through hole structure in the above embodiments may alternatively be a recess structure. For example, the first insulating film 111 is provided with a first recess 122A, and the second insulating film 112 is provided with a second recess 122B. The first recess 122A and the second recess 122B may be structures having the same shape or different shapes. Alternatively, one of the first insulating film 111 and the second insulating film 112 may be provided with a through hole 121, and the other may be provided with a recess 122. The through hole 121A or the recess 122A of the first insulating film 111 and the through hole 121B or the recess 122B of the second insulating film 112 may have the same shape or different shapes.

In a first specific embodiment, as shown in FIG. 6, the first recess 122A and the second recess 122B each include a second body portion 122a. The second body portion 122a is specifically a rectangular groove, and along an extension direction of the second body portion 122a, both ends of the second body portion 122a are provided with second arc portions 122b, and the second arc portion 122b is an arc groove structure (having a bottom wall 122d). Specifically, the second arc portion 122b is specifically a circular arc groove. In another specific embodiment, as shown in FIG. 10, the first recess 122A and the second recess 122B each may be an elongated groove structure, that is, both the first recess 122A and the second recess 122B have second arc walls 122c on both sides of the width direction Y.

It can be understood that for the through hole 121 and the recess 122, the through hole 121 deforms more easily when force is applied. In other words, when the insulating film 11 is provided with the through hole 121, the connection assembly 1 can have stronger strength, and the through hole 121 further has the advantage of easy processing. On the other hand, the recess 122 has a bottom wall. After the recess 122 is provided, this position still has an isolation effect, so that a risk that welding slag enters the inner cavity of the battery module A through the weakened portion 12 can be reduced.

On the other hand , as shown in FIGS. 1 to 3, the second insulating film 112 is closer to the battery cells 2, that is, when the connection assembly 1 is mounted to the battery module A, the second insulating film 112 is located below the first insulating film 111, the connecting sheets 13 are located between the first insulating film 111 and the second insulating film 112, and both the insulating films are connected (specifically, may be bonded) to the connecting sheets 13, thereby fastening the connecting sheets 13. In addition, the connecting sheet 13 includes a connecting portion 131, the connecting portion 131 corresponds to and is connected to an electrode lead 21, the first insulating film 111 is provided with a first via hole 111a, and the second insulating film 112 is provided with a second via hole 112a, and along the height direction Z, the connecting portion 131 is located between the first via hole 111a and the second via hole 112a. Therefore, in the battery module A, in the direction from top to bottom, there are: the first via hole 111a, the connecting portion 131 of the connecting sheet 13, the second via hole 112a, and the electrode lead 21.

In this embodiment, when the connecting sheet 13 is connected (for example, welded) to the corresponding electrode lead 21, the first through hole 111a and the second via hole 112a are used as avoiding holes for the connecting sheet 13 to be connected to the corresponding electrode lead 21, facilitating the welding of the connection portion 131 and the electrode lead 21. In addition, a failure of the function of the insulating film to connect the connecting sheet 13 due to excessively high welding temperature and burn of the insulating film can be avoided, thereby improving the reliability of the connection assembly 1.

Therefore, in actual working conditions, the weakened portions 12 of the connection assembly 1 may be provided in comprehensive consideration of the above factors, that is, each weakened portion 12 may have some recesses 122 and some through holes 121.

In conclusion, in the present application, the weakened portion 12 is provided on the insulating film 11, and under the action of the expansive force from the battery cell 2, the weakened portion 12 deforms and/or fractures, thereby reducing a risk that a position where the weakened portion 12 is not provided fractures, reducing a risk of short circuit caused by the exposure of the connecting sheets 13, and improving the insulation performance and mechanical performance of the connection assembly 1 and the battery module A.

The foregoing is merely illustrative of the preferred embodiments of the present application and is not intended to limit the present application, and various changes and modifications may be made to the present application by persons skilled in the art.

## Claims

1. A connection assembly (1) for a battery module (A), wherein the connection assembly (1) comprising:
a connecting sheet (13), the connecting sheet (13) electrically connect battery cells (2) constituting the battery module (A); and
an insulating film (11), a plurality of the connecting sheets (13) are mounted onto the insulating film (11), and are insulated from each other;
wherein the insulating film (11) is provided with a weakened portion (12), and when the insulating film (11) is subjected to external force greater than a specified value, the insulating film (11) is deformed and/or broken at a position of the weakened portion (12);
wherein the weakened portion (12) is configured to prevent the exposure of the plurality of the connecting sheets (13);
wherein the insulating film (11) comprises a first insulating film (111) and a second insulating film (112);
along a height direction (Z) of the connection assembly (1), at least part of the connecting sheet (13) is located between the first insulating film (111) and the second insulating film (112);
the first insulating film (111) and the second insulating film (112) each are provided with the weakened portion (12), and along the height direction (Z) of the connection assembly (1), the weakened portion (12) of the first insulating film (111) is arranged corresponding to the weakened portion (12) of the second insulating film (112); and
**characterized in that**
along the height direction (Z) of the connection assembly (1), the weakened portion (12) of the first insulating film (111) and the weakened portion (12) of the second insulating film (112) are arranged in a staggered manner.

2. The connection assembly (1) according to claim 1, wherein the weakened portion (12) is a through hole (121) and/or a recess (122) and comprises a first body portion (121a) and a first arc portion (121b); and
along an extension direction of the first body portion (121a), an end of the first body portion (121a) are connected to the first arc portion (121b).

3. The connection assembly (1) according to claim 2, wherein a section of the first body portion (121a) is rectangular, the first arc portion (121b) is a circular arc structure, and the first arc portion (121b) is tangent to two side walls of the first body portion (121a); and
a diameter D of the first arc portion (121b) is equal to a width dimension a of the first body portion (121a); or
wherein the first arc portion (121b) is a circular structure having an opening (121g), and the first arc portion (121b) communicates with the first body portion (121a) through the opening (121g); and
a diameter D of the first arc portion (121b) is greater than a width dimension a of the first body portion (121a).

4. The connection assembly (1) according to any one of claims 1 to 3, wherein along the height direction (Z), the first insulating film (111) and the second insulating film (112) overlap together, and an overlapping part of the two is between the weakened portion (12) of the first insulating film (111) and the weakened portion (12) of the second insulating film (112).

5. The connection assembly (1) according to any one of claims 1 to 4, wherein the weakened portion (12) of the first insulating film (111) is provided as a first through hole (121A), and the weakened portion (12) of the second insulating film (112) is provided as a second through hole (121B).

6. The connection assembly (1) according to claim 5, wherein a width dimension a of the first through hole (121A) is smaller than a width dimension b of the second through hole (121B); and/or
wherein a length dimension L1 of the first through hole (121A) is greater than a length dimension L2 of the second through hole (121B).

7. The connection assembly (1) according to any one of claims 1 to 4, wherein the first insulating film (111) is provided with a first via hole (111a), and the second insulating film (112) is provided with a second via hole (112a); and
along the height direction (Z) of the connection assembly (1), a connecting portion (131) of the connecting sheet (13) is between the first via hole (111a) and the second via hole (112a).

8. The connection assembly (1) according to any one of claims 1 to 3, wherein the connection assembly (1) further comprises a circuit board (14), the circuit board (14) is configured to be electrically connected to the connecting sheet (13), and the insulating film (11) connects the circuit board (14) and the connecting sheet (13) together.

9. The connection assembly (1) according to claim 8, wherein the weakened portion (12) is located between the adjacent connecting sheets (13), and/or the weakened portion (12) is located between the connecting sheet (13) and the circuit board (14).

10. A battery module (A), wherein the battery module (A) comprising:
a battery cell (2), wherein the battery cell (2) comprises electrode leads (21); and
a connection assembly (1), wherein the connection assembly (1) is the connection assembly (1) according to any one of claims 1 to 9;
a connecting portion (131) of the connecting sheet (13) is configured to connect the electrode leads (21) of the battery cell (2).

11. A battery pack (P), wherein the battery pack comprises a box body (B) and the battery module (A) according to claim 10, and the battery module (A) is fastened in the box body (B).

12. A device, using a battery cell (2) as a power supply, wherein the device comprising:
a power source, the power source is configured to provide driving force for the device; and
the battery module (A) according to claim 11 configured to provide electrical energy for the power source.

## Patentansprüche

1. Verbindungsanordnung (1) für ein Batteriemodul (A), wobei die Verbindungsanordnung (1) umfasst:
eine Verbindungsplatte (13), wobei die Verbindungsplatte (13) Batteriezellen (2), die das Batteriemodul (A) bilden, elektrisch verbindet; und
eine Isolierlage (11), wobei mehrere Verbindungsplatten (13) auf der Isolierlage (11) montiert und voneinander isoliert sind;
wobei die Isolierlage (11) mit einem Schwächungsabschnitt (12) versehen ist und, wenn die Isolierlage (11) einer äußeren Kraft ausgesetzt ist, die größer als ein festgelegter Wert ist, die Isolierlage (11) an einer Stelle des Schwächungsabschnitts (12) verformt und/oder zerbrochen wird;
wobei der Schwächungsabschnitt (12) dazu ausgestaltet ist, die Freilegung der mehreren Verbindungsplatten (13) zu verhindern;
wobei die Isolierlage (11) eine erste Isolierlage (111) und eine zweite Isolierlage (112) umfasst;
entlang einer Höhenrichtung (Z) der Verbindungsanordnung (1) wenigstens ein Teil der Verbindungsplatte (13) sich zwischen der ersten Isolierlage (111) und der zweiten Isolierlage (112) befindet;
die erste Isolierlage (111) und die zweite Isolierlage (112) jeweils mit dem Schwächungsabschnitt (12) versehen sind und entlang der Höhenrichtung (Z) der Verbindungsanordnung (1) der Schwächungsabschnitt (12) der ersten Isolierlage (111) entsprechend dem Schwächungsabschnitt (12) der zweiten Isolierlage (112) angeordnet ist; und **dadurch gekennzeichnet, dass**
entlang der Höhenrichtung (Z) der Verbindungsanordnung (1) der Schwächungsabschnitt (12) der ersten Isolierlage (111) und der Schwächungsabschnitt (12) der zweiten Isolierlage (112) versetzt angeordnet sind.

2. Verbindungsanordnung (1) nach Anspruch 1, wobei der Schwächungsabschnitt (12) ein Durchgangsloch (121) und/oder eine Aussparung (122) ist und einen ersten Körperabschnitt (121a) und einen ersten Bogenabschnitt (121b) umfasst; und
entlang einer Erstreckungsrichtung des ersten Körperabschnitts (121a) ein Ende des ersten Körperabschnitts (121a) mit dem ersten Bogenabschnitt (121b) verbunden ist.

3. Verbindungsanordnung (1) nach Anspruch 2, wobei ein Teilstück des ersten Körperabschnitts (121a) rechteckig ist, der erste Bogenabschnitt (121b) eine Kreisbogenstruktur ist und der erste Bogenabschnitt (121b) zwei Seitenwände des ersten Körperabschnitts (121a) berührt; und
ein Durchmesser D des ersten Bogenabschnitts (121b) gleich einer Breitenabmessung a des ersten Körperabschnitts (121a) ist; oder
wobei der erste Bogenabschnitt (121b) eine Kreisstruktur mit einer Öffnung (121g) ist und der erste Bogenabschnitt (121b) über die Öffnung (121g) mit dem ersten Körperabschnitt (121a) in Verbindung steht; und
ein Durchmesser D des ersten Bogenabschnitts (121b) größer als eine Breitenabmessung a des ersten Körperabschnitts (121a) ist.

4. Verbindungsanordnung (1) nach einem der Ansprüche 1 bis 3, wobei entlang der Höhenrichtung (Z) die erste Isolierlage (111) und die zweite Isolierlage (112) einander überlappen und ein überlappender Teil der beiden zwischen dem Schwächungsabschnitt (12) der ersten Isolierlage (111) und dem Schwächungsabschnitt (12) der zweiten Isolierlage (112) liegt.

5. Verbindungsanordnung (1) nach einem der Ansprüche 1 bis 4, wobei der Schwächungsabschnitt (12) der ersten Isolierlage (111) als ein erstes Durchgangsloch (121A) vorgesehen ist und der Schwächungsabschnitt (12) der zweiten Isolierlage (112) als ein zweites Durchgangsloch (121B) vorgesehen ist.

6. Verbindungsanordnung (1) nach Anspruch 5, wobei eine Breitenabmessung a des ersten Durchgangslochs (121A) kleiner als eine Breitenabmessung b des zweiten Durchgangslochs (121B) ist; und/oder
wobei eine Längenabmessung L1 des ersten Durchgangslochs (121A) größer als eine Längenabmessung L2 des zweiten Durchgangslochs (121B) ist.

7. Verbindungsanordnung (1) nach einem der Ansprüche 1 bis 4, wobei die erste Isolierlage (111) mit einem ersten Durchkontaktierungsloch (111a) versehen ist und die zweite Isolierlage (112) mit einem zweiten Durchkontaktierungsloch (112a) versehen ist; und
entlang der Höhenrichtung (Z) der Verbindungsanordnung (1) ein Verbindungsabschnitt (131) der Verbindungsplatte (13) zwischen dem ersten Durchkontaktierungsloch (111a) und dem zweiten Durchkontaktierungsloch (112a) liegt.

8. Verbindungsanordnung (1) nach einem der Ansprüche 1 bis 3, wobei die Verbindungsanordnung (1) ferner eine Leiterplatte (14) umfasst, die Leiterplatte (14) dazu ausgestaltet ist, elektrisch mit der Verbindungsplatte (13) verbunden zu werden, und die Isolierlage (11) die Leiterplatte (14) und die Verbindungsplatte (13) miteinander verbindet.

9. Verbindungsanordnung (1) nach Anspruch 8, wobei der Schwächungsabschnitt (12) sich zwischen den benachbarten Verbindungsplatten (13) befindet und/oder der Schwächungsabschnitt (12) sich zwischen der Verbindungsplatte (13) und der Leiterplatte (14) befindet.

10. Batteriemodul (A), wobei das Batteriemodul (A) umfasst:
eine Batteriezelle (2), wobei die Batteriezelle (2) Elektrodenzuführungen (21) umfasst; und
eine Verbindungsanordnung (1), wobei die Verbindungsanordnung (1) die Verbindungsanordnung (1) nach einem der Ansprüche 1 bis 9 ist;
wobei ein Verbindungsabschnitt (131) der Verbindungsplatte (13) dazu ausgestaltet ist, die Elektrodenzuführungen (21) der Batteriezelle (2) zu verbinden.

11. Batteriepack (P), wobei das Batteriepack einen Kastenkörper (B) und das Batteriemodul (A) nach Anspruch 10 umfasst und das Batteriemodul (A) in dem Kastenkörper (B) befestigt ist.

12. Vorrichtung, die eine Batteriezelle (2) als Stromversorgung nutzt, wobei die Vorrichtung umfasst:
eine Stromquelle, wobei die Stromquelle dazu ausgestaltet ist, Antriebskraft für die Vorrichtung bereitzustellen; und
das Batteriemodul (A) nach Anspruch 11, das dazu ausgestaltet ist, elektrische Energie für die Stromquelle bereitzustellen.

## Revendications

1. Ensemble de connexion (1) pour un module de batterie (A), l'ensemble de connexion (1) comprenant :
une feuille de connexion (13), la feuille de connexion (13) connectant électriquement des cellules de batterie (2) constituant le module de batterie (A) ; et
un film isolant (11), une pluralité de feuilles de connexion (13) étant montées sur le film isolant (11), et étant isolées les unes des autres ;
le film isolant (11) étant pourvu d'une partie affaiblie (12), et lorsque le film isolant (11) est soumis à une force externe supérieure à une valeur spécifiée, le film isolant (11) étant déformé et/ou rompu à une position de la partie affaiblie (12) ;
la partie affaiblie (12) étant configurée pour empêcher l'exposition de la pluralité des feuilles de connexion (13) ;
le film isolant (11) comprenant un premier film isolant (111) et un second film isolant (112) ;
le long d'une direction de hauteur (Z) de l'ensemble de connexion (1), au moins une partie de la feuille de connexion (13) étant située entre le premier film isolant (111) et le second film isolant (112) ;
le premier film isolant (111) et le second film isolant (112) étant chacun pourvus de la partie affaiblie (12), et le long de la direction de la hauteur (Z) de l'ensemble de connexion (1), la partie affaiblie (12) du premier film isolant (111) étant agencée en correspondance à la partie affaiblie (12) du second film isolant (112) ; et **caractérisé en ce que**
le long de la direction de la hauteur (Z) de l'ensemble de connexion (1), la partie affaiblie (12) du premier film isolant (111) et la partie affaiblie (12) du second film isolant (112) sont agencées d'une manière décalée.

2. Ensemble de connexion (1) selon la revendication 1, la partie affaiblie (12) étant un trou traversant (121) et/ou un évidement (122) et comprenant une première partie de corps (121a) et une première partie d'arc (121b) ; et
le long d'une direction d'extension de la première partie de corps (121a), une extrémité de la première partie de corps (121a) étant reliée à la première partie d'arc (121b).

3. Ensemble de connexion (1) selon la revendication 2, une section de la première partie de corps (121a) étant rectangulaire, la première partie d'arc (121b) étant une structure d'arc circulaire, et la première partie d'arc (121b) étant tangente à deux parois latérales de la première partie de corps (121a) ; et
un diamètre D de la première partie d'arc (121b) étant égal à une dimension de largeur a de la première partie de corps (121a) ; ou
la première partie d'arc (121b) étant une structure circulaire ayant une ouverture (121g), et la première partie d'arc (121b) communiquant avec la première partie de corps (121a) à travers l'ouverture (121g) ; et
un diamètre D de la première partie d'arc (121b) étant supérieur à une dimension de largeur a de la première partie de corps (121a).

4. Ensemble de connexion (1) selon l'une quelconque des revendications 1 à 3, le long de la direction de la hauteur (Z), le premier film isolant (111) et le second film isolant (112) se chevauchant ensemble, et une partie de chevauchement des deux étant entre la partie affaiblie (12) du premier film isolant (111) et la partie affaiblie (12) du second film isolant (112).

5. Ensemble de connexion (1) selon l'une quelconque des revendications 1 à 4, la partie affaiblie (12) du premier film isolant (111) étant prévue comme un premier trou traversant (121A), et la partie affaiblie (12) du second film isolant (112) étant prévue comme un second trou traversant (121B).

6. Ensemble de connexion (1) selon la revendication 5, une dimension de largeur a du premier trou traversant (121A) étant inférieure à une dimension de largeur b du second trou traversant (121B) ; et/ou
une dimension de longueur L1 du premier trou traversant (121A) étant supérieure à une dimension de longueur L2 du second trou traversant (121B).

7. Ensemble de connexion (1) selon l'une quelconque des revendications 1 à 4, le premier film isolant (111) étant pourvu d'un premier trou de passage (111a), et le second film isolant (112) étant pourvu d'un second trou de passage (112a) ; et
le long de la direction de la hauteur (Z) de l'ensemble de connexion (1), une partie de connexion (131) de la feuille de connexion (13) étant entre le premier trou de passage (111a) et le second trou de passage (112a).

8. Ensemble de connexion (1) selon l'une quelconque des revendications 1 à 3, l'ensemble de connexion (1) comprenant en outre une carte de circuit imprimé (14), la carte de circuit imprimé (14) étant configurée pour être connectée électriquement à la feuille de connexion (13), et le film isolant (11) connectant la carte de circuit imprimé (14) et la feuille de connexion (13) ensemble.

9. Ensemble de connexion (1) selon la revendication 8, la partie affaiblie (12) étant située entre les feuilles de connexion adjacentes (13), et/ou la partie affaiblie (12) étant située entre la feuille de connexion (13) et la carte de circuit imprimé (14).

10. Module de batterie (A), le module de batterie (A) comprenant :
une cellule de batterie (2), la cellule de batterie (2) comprenant des conducteurs d'électrode (21) ; et
un ensemble de connexion (1), l'ensemble de connexion (1) étant l'ensemble de connexion (1) selon l'une quelconque des revendications 1 à 9 ;
une partie de connexion (131) de la feuille de connexion (13) étant configurée pour connecter les conducteurs d'électrode (21) de la cellule de batterie (2).

11. Ensemble de batterie (P), l'ensemble de batterie comprenant un corps de boîte (B) et le module de batterie (A) selon la revendication 10, et le module de batterie (A) étant fixé dans le corps de boîte (B).

12. Dispositif, utilisant une cellule de batterie (2) comme alimentation électrique, le dispositif comprenant :
une source d'alimentation, la source d'alimentation étant configurée pour fournir une force d'entraînement pour le dispositif ; et
le module de batterie (A) selon la revendication 11 configuré pour fournir de l'énergie électrique à la source d'alimentation.
